# EUROPÄISCHE PATENTSCHRIFT

(11) **EP 3 219 179 B1**
(45) Veröffentlichungstag und Bekanntmachung des Hinweises auf die Patenterteilung: **27.12.2023**
(21) Anmeldenummer: 15795135.1
(22) Anmeldetag: 09.11.2015
(51) Int. Cl.: H05K 5/02, B65D 81/02, G11B 33/08

(54) **GEHÄUSE**
HOUSING
BOÎTIER

(30) Priorität: 12.11.2014 DE 102014016742
(43) Veröffentlichungstag der Anmeldung: 20.09.2017
(73) Patentinhaber: Eaton Protection Systems IP GmbH & Co. KG, 12529 Schönefeld (DE)
(72) Erfinder: OTT, Toni, 69151 Neckargemünd (DE); NAUMANN, Reiner, 68239 Mannheim (DE)
(74) Vertreter: Novagraaf Group
(86) Internationale Anmeldenummer: PCT/EP2015/076050
(87) Internationale Veröffentlichungsnummer: WO 2016/075073

(56) Entgegenhaltungen:
- WO-A1-95/14366
- DE-A1- 2 435 140
- GB-A- 2 401 416
- US-A1- 2014 121 743
- US-B1- 7 471 509
- Phoenix Contact: "Explosion protection Theory and practice", , 25 October 2010 (2010-10-25), pages 1-60, XP055756237, DOI: MNR5149416 Retrieved from the Internet: URL:https://www.phoenixcontact.com/assets/ downloads_ed/global/web_dwl_technical_info /5149416_EN_HQ_LR.pdf [retrieved on 2020-12-03]

## Beschreibung

Die Erfindung betrifft ein Gehäuse eines elektrischen/elektronischen Betriebsmittels. Solche Betriebsmittel sind beispielsweise Leuchten, Klemmkästen, Steuerungsgeräte, Schaltverteilanlagen oder dergleichen.

Entsprechende Betriebsmittel können auch im explosionsgefährdeten Bereich eingesetzt werden. Ein solches Gehäuse weist zumindest eine zur äußeren Umgebung weisende Seitenfläche auf.

Wie bereits ausgeführt, sind solche Gehäusen in explosionsgefährdeten Bereichen einsetzbar, und sollen ggf. auch Stößen von außen widerstehen können. Um die entsprechende Stoßfestigkeit eines solchen Gehäuses testen zu können, gibt es vorgegebene Testbedingungen nach IEC 60079 für einen entsprechenden Stoßtest, bei dem beispielsweise Stoßenergien in der Größenordnung von 4 J, 7 J, 20 J oder dergleichen zur Überprüfung der Stabilität des Gehäuses ausgeübt werden. Um bisher eine ausreichende Stoßfestigkeit des Gehäuses sicherzustellen, wurde dieses aus einem entsprechenden Material, wie beispielsweise Aluminium, Polyester (kann auch ggf. glasfaserverstärkt), Polyamid oder dergleichen hergestellt. Dabei ist in der Regel eine bestimmte Materialstärke erforderlich, um den Stoßtest zu bestehen.

Nachteilig bei dem vorbekannten Gehäusen ist, dass eine entsprechende Materialstärke verwendet werden muss, die das Gehäuse teurer und schwerer macht. Weiterhin wird durch die entsprechende Materialstärke der Abtransport von innerhalb des Gehäuses erzeugter Wärme erschwert, sodass zusätzliche oder ausreichend dimensioniert Kühleinrichtungen benötigt werden.

DE 24 35 140 A1 beschreibt ein stoßgeschütztes Gerät der Nachrichtentechnik mit abgeflachten Ecken, in denen jeweils kugelähnliche Stoßdämpfer aus elastischem Material angeordnet sind. Diese sollen insbesondere bei einem Fallen des Gerätes eine Beschädigung verhindern.

US 7,471,509 B1 beschreibt eine zusätzliche Umhüllung für ein Laufwerk zur Stoßabsorption. Die zusätzliche Umhüllung besteht aus zwei separaten Teilen, die von oben und von unten auf das Laufwerk aufgesetzt und dort insbesondere Kanten des Laufwerks gegen Stöße schützen sollen.

WO 95/14366 A1 beschreibt eine Fernsteuerung, die an einigen Stellen auf ihrer Oberfläche rippenartige Strukturen aufweist, die die Fernsteuerung von Stößen oder einem Fall schützen sollen. Viele Bereiche der Fernsteuerung sind ungeschützt, insbesondere solche Bereiche, wo Tasten oder andere Einrichtungen zur Bedienung und zur Verwendung der Fernsteuerung angeordnet sind.

Aufgabe der vorliegenden Erfindung ist, ein Gehäuse der eingangs genannten Art dahingehend zu verbessern, dass auch mit relativ geringer Materialstärke eine ausreichende Festigkeit des Gehäuses gegeben ist und gleichzeitig keine zusätzlichen Maßnahmen zur Kühlung erforderlich sind.

Diese Aufgabe wird durch die Merkmale des Patentanspruchs 1 gelöst. Insbesondere zeichnet sich die Erfindung dadurch aus, dass eine Mehrzahl von Aufpralldämpfern von der Seitenfläche vorstehend auf dieser angeordnet sind. Bei entsprechenden Schlägen oder auch bei dem beschriebenen Stoßtest erfolgt ein Aufprall auf einen oder mehrere dieser Aufpralldämpfer. Diese stehen von der Seitenfläche vor und nehmen einen Großteil der entsprechenden Stoßenergie auf. Dadurch wird die Übertragung von Stoßenergie direkt auf entsprechende Seitenflächen des Gehäuses oder auf elektrische/elektronische Einrichtungen innerhalb des Gehäuses stark vermindert.

Eine entsprechende Beschädigung des Gehäuses oder darin angeordneter Teile wird auf diese Weise vermieden.

Die erfindungsgemäßen Aufpralldämpfer weisen weiterhin den Vorteil auf, dass diese auch bei niedrigen Umgebungstemperaturen einsetzbar sind. Ansonsten mussten insbesondere Kunststoffmaterialien, die bei niedrigen Temperaturen ggf. brüchiger werden, entsprechend mit größerer Materialstärke oder mit zusätzlichen Verstärkungsmitteln innerhalb des Gehäuses ausgebildet werden.

Insgesamt ergibt sich erfindungsgemäß eine einfache und kostengünstige Maßnahme, die die Stoßfestigkeit eines entsprechenden Gehäuses unabhängig von der Temperatur bei gleichzeitiger reduzierter Wandstärke des entsprechenden Gehäuses gewährleistet.

Um die entsprechende Seitenfläche über ihre gesamte Ausdehnung mit Aufpralldämpfern schützen zu können, können diese rippenförmig oder lamellenförmig ausgebildet sein. Es ist ebenfalls denkbar, dass jeder Aufpralldämpfer als Einzelelement ausgebildet ist und eine Mehrzahl von diesen beispielsweise in Reihen und/oder Spalten auf der Seitenfläche angeordnet sind.

Durch Verwendung entsprechender rippenförmiger oder lamellenförmiger Aufpralldämpfer ergibt sich außerdem eine erhöhte Festigkeit für das Gehäuse und insbesondere die entsprechende Wandfläche bzw. Seitenfläche, sodass ggf. die Materialstärke dieser Wand bzw. des Gehäuses weiter reduziert werden kann. Bei einem einfachen Ausführungsbeispiel können die Aufpralldämpfer jeweils den gleichen Querschnitt aufweisen. Ein denkbarer Querschnitt ist beispielsweise ein spitzwinkliges Dreieck, eine Rechteckform, ein kegelstumpfförmiger Querschnitt oder dergleichen. Entsprechende Gehäuse können auch nebeneinander angeordnet sein, wobei auf Seitenflächen, die mit Seitenflächen anderer Gehäuse in Kontakt sind, keine entsprechenden Aufpralldämpfer angeordnet sein müssen. Allerdings können die Aufpralldämpfer ansonsten von allen Seitenflächen und insbeinsbesondere auch im Bereich von Verbindungskanten zwischen solchen Seitenflächen vorstehen. Auch auf einem Deckel eines Gehäuses können Aufpralldämpfer angeordnet sein. Insbesondere in explosionsgefährdeten Bereichen können solche Aufpralldämpfer eine Beschädigung des Gehäuses vermeiden, wobei das erfindungsgemäße Gehäuse als explosionsgeschützte Gehäuse ausgebildet sind.

Je nach Erfordernis, können auch Aufpralldämpfer mit unterschiedlichen Querschnittsformen, unterschiedlichen Dicken, unterschiedlichen Längen, in unterschiedlichen Dichten, mit unterschiedlichen Ausrichtungen und/oder Formen vorgesehen sein. Insbesondere im Bereich von Verbindungskanten kann es sich als vorteilhaft erweisen, wenn die Dichte der Anordnung solcher Aufpralldämpfer in diesen Bereichen erhöht ist. Ebenso kann es von Vorteil sein, wenn beispielsweise auf bestimmten Seitenflächen, die einer äußeren Umgebung zugeordnet sind, von der Stöße eher zu erwarten sind als auf anderen Seitenflächen, beispielsweise die Aufpralldämpfer mit größerer Dicke und/oder größerer Länge, und/oder in größerer Dichte angeordnet sind.

In der Regel erweist es sich weiterhin als Vorteilhaft, wenn ein solcher Aufpralldämpfer sich senkrecht von der entsprechenden Seitenfläche absteht. Dadurch wird die entsprechend von der äu-ßeren Umgebung aufgenommene Stoßenergie günstigerweise auf das Gehäuse abgeleitet und ggf. auch auf benachbarte Aufpralldämpfer verteilt.

Bei bestimmten Anordnungen des Gehäuses oder auch zur entsprechenden Aufnahme von Sto-ßenergie kann es weiterhin als günstig betrachtet werden, wenn ein entsprechender Aufpralldämpfer sich geneigt zur Ebene der Außenseite erstreckt. D.h., ein entsprechender Aufpralldämpfer ist in einer bestimmten Neigung relativ zur Seitenfläche angeordnet. Es ist weiterhin denkbar, dass der Aufpralldämpfer eine Sollbruchstelle aufweist, sodass bei entsprechend hoher Stoßenergie der Aufpralldämpfer umgebogen oder gar abgeschlagen wird.

Durch die Verwendung der Aufpralldämpfer ist eine geringere Wandstärke für das Gehäuse möglich, sodass eine bessere Wärmeableitung zur äußeren Umgebung erfolgen kann. Um diese Wärmeableitung weiterhin zu verbessern, ist es als günstig zu betrachten, wenn ggf. die Aufpralldämpfer als Kühlelemente einsetzbar sind. D.h., durch die Aufpralldämpfer wird die Oberfläche des Gehäuses erhöht und die gesamte vergrößerte Oberfläche kann zur Abgabe der Wärme an die äußere Umgebung verwendet werden. Dabei ist keine zusätzliche Anordnung einer Kühleinrichtung erforderlich. Um entsprechend als Kühlelement eingesetzt werden zu können, erweist es sich in diesem Zusammenhang weiter hin als Vorteil, wenn die Aufpralldämpfer aus einem Material mit ausreichender thermischer Konduktivität hergestellt sind.

Sowohl für eine solche erhöhte thermische Konduktivität als auch zur verbesserten Anpassung der Aufpralldämpfer an Stöße, kann es sich weiterhin als vorteilhaft erweisen, wenn die Aufpralldämpfer aus einem anderen Material wie das Gehäuse gebildet sind. Es besteht in diesem Zusammenhang ebenfalls die Möglichkeit, dass nur einige Aufpralldämpfer oder beispielsweise die einer Seitenfläche zugeordneten Aufpralldämpfer aus einem bestimmten Material sind, welches z.B. unterschiedlich zum Material des Gehäuses und ggf. auch unterschiedlich zum Material von Aufpralldämpfern an anderen Seitenflächen ist. Das Material kann auch dahingehend ausgewählt werden, dass die Aufpralldämpfer zur Aufnahme von Stoßenergie, insbesondere bei einer Schlagprüfung, flexibel sind.

Um ggf. bei Brechen eines Aufpralldämpfers diese zu ersetzen oder zur Anordnung anderer Aufpralldämpfer mit anderer Länge, anderer Dicke, anderem Querschnitt, aus anderem Material oder dergleichen, kann es sich weiterhin als günstig erweisen, wenn entsprechende Aufpralldämpfer an der Seitenfläche des Gehäuses lösbar befestigt sind. Dadurch sind die Aufpralldämpfer einfach befestigbar und austauschbar.

Andererseits kann es weiterhin zur Vereinfachung der Herstellung des Gehäuses von Vorteil sein, wenn die Aufpralldämpfer einteilig mit dem Gehäuse hergestellt sind.

Um ggf. ganze Gruppen von Aufpralldämpfern im Bereich einer Seitenfläche oder für eine gesamte Seitenfläche oder dergleichen austauschen zu können, kann es weiterhin von Vorteil sein, wenn die Aufpralldämpfer gruppenweise handhabbar und an der Seitenfläche anbringar sind. Auf diese Weise muss beispielsweise nicht ein einzelner Aufpralldämpfer angebracht oder gelöst werden, sondern dies erfolgt gruppenweise.

Bei einer vorteilhaften Weiterbildung der Erfindung können die Aufpralldämpfer am freien Ende eine Abflachung und/oder Abrundung aufweisen. D.h., die entsprechende Aufpralldämpferspitze weißt eine Schräge oder Abrundung auf, welche verhindert, dass ein

Schlag senkrecht zum Gehäuse die Kraft ggf. direkt auf das Gehäuse überträgt oder den Aufpralldämpfer überlastet. Durch die Schräge bzw. Abrundung wird ein Lastangriff mittig zum Aufpralldämpfer verhindert und ein Abrutschen des aufprallenden Körpers erzwungen. Dadurch wird die Kraft zwischen benachbarten Aufpralldämpfern verteilt, da beispielsweise auch Kraft auf benachbarte Aufpralldämpfer eingeleitet wird. Vorteilhafterweise kann ein entsprechender Winkel zwischen Abflachung und Seitenfläche des Gehäuses größer als 0° und kleiner als 90° sein. Besonders bevorzugt kann dieser Winkel größer als 10° und kleiner als 80° und weiterhin bevorzugt größer als 20° und kleiner als 70° sein. Ebenso gilt, dass ein Winkel dieser Abflachung relativ zu einer Längsachse des Aufpralldämpfers bei dessen gerader Ausführung ungleich 90° ist.

Im Folgenden werden vorteilhafte Ausführungsbeispiele der Erfindung anhand der in Zeichnungen beigefügten Figuren näher erläutert.

Es zeigen:
- Figur 1: eine Draufsicht auf eine erfindungsgemäßes Gehäuse mit Testvorrichtung;
- Figur 2: eine Draufsicht auf ein weiteres Gehäuse mit unterschiedlichen Anordnungen von Aufpralldämpfern;
- Figur 3: eine vergrößerte Darstellung des Details "X" aus Figur 1 und
- Figur 4 bis 12: verschiedene Ausführungsbeispiele für Aufpralldämpfer.

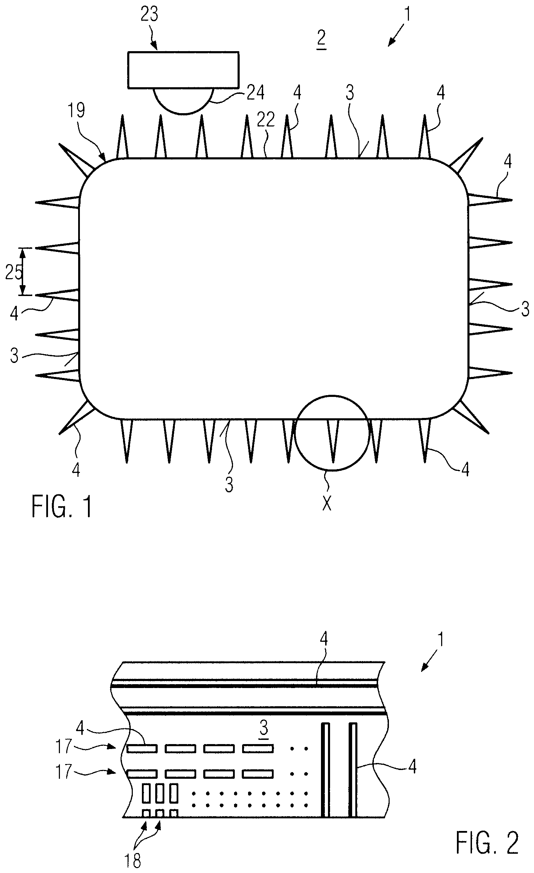

Figur 1 zeigt eine Draufsicht auf ein Ausführungsbeispiel eines Gehäuses 1 mit einer Vielzahl von Aufpralldämpfern 4. Das Gehäuse 1 weist einen etwa rechteckförmigen Querschnitt mit gerundeten Verbindungskanten 19 zwischen entsprechenden Seitenflächen 3 auf. Auf den Seitenflächen sind in Richtung äußerer Umgebung 2 vorstehende Aufpralldämpfer 4 angeordnet. Diese weisen einen etwa dreieckförmigen Querschnitt, insbesondere eines spitzwinkligen Dreiecks auf. Die Aufpralldämpfer 4 erstrecken sich senkrecht zur Figurenebene entlang der entsprechenden Seitenflächen 3 allseitig um das Gehäuse 1. Entsprechende Aufpralldämpfer 4 können ebenfalls auf der Oberseite und/oder der Unterseite des Gehäuses 1 angeordnet sein. Auf entsprechenden Seitenflächen, die anderen benachbarten Gehäusen zugeordnet und mit diesen in Kontakt sind oder an einer Befestigungsfläche angebracht sind, fehlen entsprechende Aufpralldämpfer. Beim Ausführungsbeispiel nach Figur 1 erstrecken sich die entsprechenden Aufpralldämpfer 4 senkrecht zu einer Ebene 22 der Seitenfläche 3. Die Aufpralldämpfer 4 sind in einem Abstand 25 angeordnet, der geringer als eine entsprechende Breite eines Testelements 24, wie einer Schlagkugel mit Durchmesser von beispielsweise 25 mm, einer Testvorrichtung 23 ist. Eine solche Testvorrichtung 23 dient zur Durchführung eines Stoßtestes.

Die entsprechenden Aufpralldämpfer 4 dienen gleichzeitig als Kühlelemente und sind an der Seitenfläche 3 angebracht. Dieses Anbringen kann lösbar erfolgen, sodass jeder Aufpralldämpfer entfernbar und durch einen anderen ersetzbar ist. Bei einem anderen Ausführungsbeispiel können die Aufpralldämpfer einteilig mit dem Gehäuse 1 ausgebildet sein. Das Material der Aufpralldämpfer kann unterschiedlich zum Material des Gehäuses sein, um beispielsweise die Aufpralldämpfer mit einer verbesserten Temperaturbeständigkeit insbesondere im Hinblick auf kalte Temperaturen, einer entsprechenden Flexibilität zur Absorption von Stoßenergie und dergleichen auszubilden.

Bei dem dargestellten Ausführungsbeispiel nach Figur 1 sind die Aufpralldämpfer im Wesentlichen rippenförmig oder lamellenförmig angeordnet und erstrecken sich entlang der gesamten Seitenfläche 3.

Es ist in anderen Ausführungsbeispielen möglich, dass entsprechende Aufpralldämpfer 4 mit unterschiedlichen Formen, unterschiedlichen Querschnitten, unterschiedlichen Ausrichtungen, unterschiedlichen Dichten, unterschiedlichen Längen und dergleichen angeordnet sind. Bei dem dargestellten Ausführungsbeispiel weisen alle Aufpralldämpfer im Wesentlichen den gleichen Querschnitt und die gleiche Höhe relativ zur Seitenfläche 3 auf. Außerdem ist die Dichte der Anordnung der Aufpralldämpfer im Wesentlichen konstant.

In Figur 2 sind unterschiedliche Anordnungen der Aufpralldämpfer 4 auf einer Seitenfläche 3 dargestellt. Im oberen Bereich erstrecken sich zwei rippenförmige Aufpralldämpfer 4 über die gesamte Breite der Seitenfläche 3. Im unteren rechten Teil erstrecken sich senkrecht zu den vorangehend genannten Aufpralldämpfern zumindest zwei rippenförmige Aufpralldämpfer, wobei weitere dieser Aufpralldämpfer vorhanden sein können.

Im übrigen Teil der Figur 2 sind verschiedene einzelne Aufpralldämpfer dargestellt, die in Reihen 17 und Spalten 18 angeordnet sind.

Es ist vorstellbar, dass alle in Figur 2 dargestellten Anordnungen der Aufpralldämpfer auf einer entsprechenden Seitenfläche 3 vorhanden sind. In der Regel wird allerdings eine Anordnung bevorzugt werden, da dies einfacher herstellbar ist.

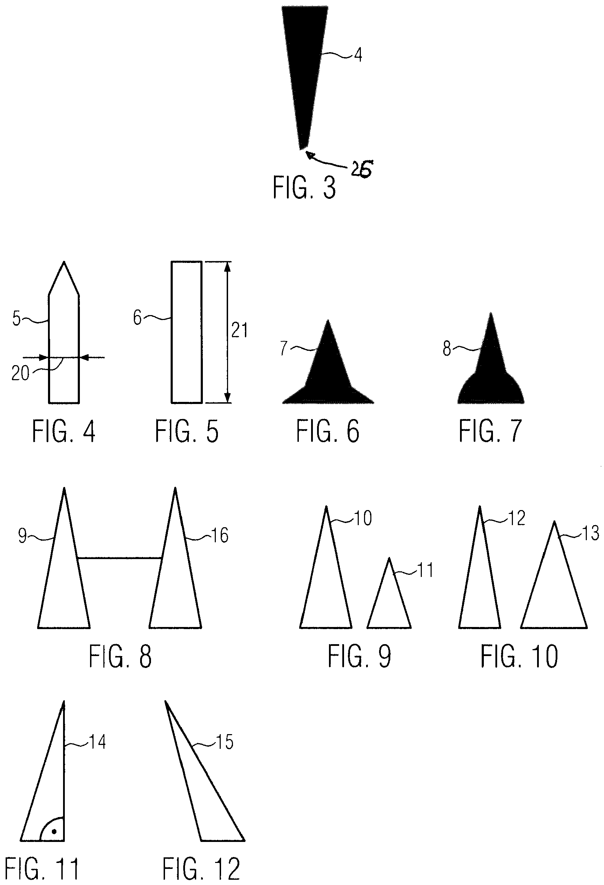

In den folgenden Figuren sind unterschiedliche Ausführungsbeispiele eines Aufpralldämpfers dargestellt, wobei Figur 3 insbesondere eine vergrößerte Ansicht des Details "X" aus Figur 1 darstellt.

Nach Figur 3 weist der Aufpralldämpfer einen spitzwinkligen Dreiecksquerschnitt auf. Eine Basis des entsprechenden Dreiecks dient zur Befestigung an der Seitenfläche 3 des Gehäuses. Diese Befestigung kann lösbar erfolgen, oder der Aufpralldämpfer 4 kann einteilig mit dem Gehäuse 1 hergestellt sein.

Bei dem dargestellten Ausführungsbeispiel des Aufpralldämpfers weißt dieser eine Abflachung 26 am freien Ende auf. Diese kann auch als Abrundung ausgebildet sein. Durch diese Abflachung bzw. Abrundung wird verhindert, dass beim Schlag senkrecht zum Gehäuse die Kraft direkt auf das Gehäuse übertragen oder der Aufpralldämpfer überlastet wird. Durch die Abflachung bzw. Abrundung wird ein Lastangriff mittig zum Aufpralldämpfer verhindert und ein Abrutschen des entsprechenden aufprallenden Körpers in Richtung der benachbarten Aufpralldämpfer erzwungen. D.h., die entsprechende Kraft wird zwischen benachbarten Aufpralldämpfern verteilt. Analog können auch die übrigen Ausführungsbeispiele des Aufpralldämpfers nach den weiteren Figuren mit einer solchen Abflachung bzw. Abrundung ausgebildet sein.

In Figur 3 ist weiterhin ein Winkel 27 zwischen Abflachung 26 und einer zugehörigen Seitenfläche 3 des Gehäuses dargestellt. Dieser Winkel ist größer als 0° und kleiner als 90° und bevorzugt größer als 10° und kleiner als 80° und insbesondere bevorzugt größer als 20° und kleiner als 70°. Der Winkel der Abflachung kann ebenso relativ zu einer Längsachse 28 des Aufpralldämpfers definiert werden, wobei er in diesem Fall ungleich 90° ist.

In den folgenden Figuren 4 bis 12 sind unterschiedliche Querschnittsformen, unterschiedliche Ausrichtungen oder auch Verbindungen zwischen benachbarten Aufpralldämpfern dargestellt.

Der Aufpralldämpfer 5 nach Figur 4 weist einen pfeilförmigen Querschnitt mit einer oberen Spitze auf. Eine entsprechende Dicke 20 des Aufpralldämpfers 5 ist bis auf die Spitze im Wesentlichen konstant. Solche Aufpralldämpfer können ebenfalls rippenförmig oder lamellenförmig, siehe beispielsweise Figur 2, auf der gesamten Außenseite des Gehäuses 1 angeordnet sein. Je nach Erfordernis können auch Aufpralldämpfer 5 mit unterschiedlichen Dicken 20 eingesetzt werden, wobei dies analog auch für die übrigen Formen der Aufpralldämpfer gilt.

An dieser Stelle sei nochmals bemerkt, dass Aufpralldämpfer 5 in der Regel auf allen freien Außenseiten des Gehäuses beziehungsweise auf den entsprechenden Seitenflächen angeordnet sein können. Seitenflächen, die mit benachbarten Gehäusen in Kontakt sind, können frei von entsprechenden Aufpralldämpfern sein. Ebenso besteht die Möglichkeit, dass ein auf ein solches Gehäuse aufsetzbarer Deckel zumindest auf seiner Oberseite auch entsprechende Aufpralldämpfer aufweist. Erstreckt sich der Deckel mit entsprechenden Seitenflächen in Richtung der Seitenflächen des Gehäuses, so können auch auf diesen Seitenflächen des Deckels entsprechende Aufpralldämpfer 5 angeordnet sein.

In Figur 5 weist der Aufpralldämpfer 6 einen im Wesentlichen rechteckförmigen Querschnitt auf, und erstreckt sich über eine Länge 21. Es ist ebenfalls möglich, dass entsprechende Aufpralldämpfer mit unterschiedlichen Längen auf einer Seitenfläche 3 angeordnet sind. Dies gilt wiederum für alle verschiedenen Formen von Aufpralldämpfern.

Weiterhin kann es bei einem Ausführungsbeispiel sein, dass Aufpralldämpfer unterschiedlicher Formen auf einer Außenseite oder in bestimmten Bereich auf der Außenseite des Gehäuses angeordnet sind.

Der Aufpralldämpfer 7 nach Figur 6 weist eine dreieckförmige Spitze auf, die sich von einer Kugelkappe erstreckt. Die Kugelkappe kontaktiert die Seitenfläche.

Der Aufpralldämpfer 8 nach Figur 7 unterscheidet sich von dem nach Figur 6 durch eine halbkreisförmigen Querschnitt des unteren Teils, auf dem die entsprechende Spitze angeordnet ist.

Die Aufpralldämpfer 9 und 16 nach Figur 8 sind analog zum Aufpralldämpfer 4 nach Figur 3 ausgebildet, wobei diese Aufpralldämpfer allerdings miteinander verbunden sind. Eine solche Verbindung kann zwischen allen Aufpralldämpfern auf der Außenseite 3 des Gehäuses 1 vorhanden sein, oder beispielsweise insbesondere bei Aufpralldämpfern im Bereich von Verbindungskanten 19, siehe Figur 1.

Es ist ebenfalls möglich, dass die Aufpralldämpfer 9 und 16 nach Figur 8 mit unterschiedlichen Querschnitten, unterschiedlichen Dicken, unterschiedlichen Längen und dergleichen ausgebildet sind.

In Figur 9 sind zwei Aufpralldämpfer 10 und 11 mit unterschiedlicher Höhe dargestellt. Diese können entsprechend auf einer Seitenfläche 3 eines Gehäuses 1 angeordnet sein.

Analog können auch Aufpralldämpfer 12, 13 nach Figur 10 mit unterschiedlichen Dicken des Querschnitts angeordnet sein, wobei es möglich ist, dass die dickeren Aufpralldämpfer 13 beispielsweise im Bereich einer Verbindungskante 19, siehe Figur 1, angeordnet sind. Wie bereits ausgeführt, sind alle Aufpralldämpfer auch in unterschiedlichen Höhen ausbildbar, was ebenfalls im Hinblick auf Figur 10 gilt.

Figur 11 zeigt einen Aufpralldämpfer 14 der einen Querschnitt eines rechtwinkligen Dreieckes aufweist, und Figur 12 zeigt einen relativ zur Ebene 22 der Außenseite 3 geneigt zu einer Seite verlaufenden Aufpralldämpfer 15.

Die dargestellten Ausführungsbeispiele sind nur exemplarisch, wobei weitere Querschnittsformen und/oder Kombinationen von Aufpralldämpfern der bereits beschriebenen Art möglich sind.

Die Aufpralldämpfer können aus einem relativ festen oder auch aus einem flexiblen Material hergestellt sein. Beispielsweise können die Aufpralldämpfer Sollbruchstellen aufweisen, sodass bei einer bestimmten Stoßenergie ein Abbrechen eines Aufpralldämpfers erfolgt. Analog kann eine flexible Verformung eines Aufpralldämpfers oder auch von Gruppen von Aufpralldämpfern stattfinden.

Wie bereits weiter oben ausgeführt, kann jeder Aufpralldämpfer lösbar an der Seitenfläche 3 des Gehäuses 1 befestigt sein. Dies gilt analog auch für Gruppen von Aufpralldämpfern, sodass diese gruppenweise handhabbar und an der Seitenfläche anbringbar sind.

Insbesondere sind alle dargestellten und weiteren möglichen Aufpralldämpfer gemäß vorliegender Anmeldung auch für explosionsgeschützt Gehäuse 1 einsetzbar und/oder zur Kühlung des Gehäuses.

Zwar wurde immer auf ein "Gehäuse" im vorangehenden Text verwiesen, wobei ein solches Gehäuse nicht komplett geschlossen sein muss. Beispielsweise kann "Gehäuse" auch ein Deckel eines sonstigen Gehäuses sein oder aber ein Teil des Gehäuses, auf dem ein solcher Deckel aufgesetzt wird. Natürlich sind entsprechende Aufpralldämpfer auf allen Teilen eines solchen Gehäuses, auch am Deckel, anbringbar. Ein solches Gehäuse kann auch ein Teilgehäuse sein, eine Abdeckung, eine Schutzwanne oder dergleichen, wobei entsprechende elektrische oder elektronische Betriebsmittel beispielsweise eine Schaltverteilanlage, ein Steuergerät, ein Klemmkasten, eine Leuchte oder dergleichen sind. Die erfindungsgemäßen Aufpralldämpfer haben keinen direkten Einfluss auf die Schutzart des Gehäuses, sodass diese im Wesentlichen für alle explosionsgeschützten Gehäuse unabhängig von der Schutzart einsetzbar sind, siehe beispielsweise ex-i, ex-e, ex-d oder dergleichen.

## Patentansprüche

1. Gehäuse (1) eines elektrischen/elektronischen Betriebsmittels wie Leuchte, Klemmkasten, Steuergerät, Schaltverteilanlage oder dergleichen, mit wenigstens einer zur äußeren Umgebung (2) weisenden Seitenfläche (3), wobei eine Mehrzahl von Aufpralldämpfern (4 bis 16) zumindest von der Seitenfläche (3) vorstehend auf dieser angeordnet sind, **dadurch gekennzeichnet, dass** die Aufpralldämpfer (4 bis 16) als Kühlelemente eingesetzt sind.

2. Gehäuse nach Anspruch 1, **dadurch gekennzeichnet, dass** der Aufpralldämpfer (4 bis 16) rippenförmig oder lamellenförmig ausgebildet ist, und/oder die Aufpralldämpfer (4 bis 16) in Reihen und/oder Spalten auf der Seitenfläche (3) angeordnet sind.

3. Gehäuse nach Anspruch 1 oder 2, **dadurch gekennzeichnet, dass** die Aufpralldämpfer (4 bis 16) jeweils den gleichen Querschnitt aufweisen.

4. Gehäuse nach einem der vorangehenden Ansprüche, **dadurch gekennzeichnet, dass** Aufpralldämpfer (4 bis 16) zumindest von allen Seitenflächen (3) und insbesondere von Verbindungskanten zwischen den Seitenflächen (3) vorstehen.

5. Gehäuse nach einem der vorangehenden Ansprüche, **dadurch gekennzeichnet, dass** die Aufpralldämpfer (4 bis 16) mit unterschiedlichen Querschnitten und/oder Dicken (20) und/oder Längen (21) und/oder Dichten und/oder Ausrichtungen und/oder Formen angeordnet sind, und/oder der Aufpralldämpfer (4 bis 16) im Wesentlichen senkrecht von der Seitenfläche (3) absteht.

6. Gehäuse nach einem der vorangehenden Ansprüche, **dadurch gekennzeichnet, dass** der Aufpralldämpfer (4 bis 16) sich geneigt zu einer Ebene (22) der Seitenfläche (3) erstreckt.

7. Gehäuse nach einem der vorangehenden Ansprüche, **dadurch gekennzeichnet, dass** der Aufpralldämpfer (4 bis 16) eine Sollbruchstelle aufweist.

8. Gehäuse nach einem der vorangehenden Ansprüche, **dadurch gekennzeichnet, dass** der Aufpralldämpfer (4 bis 16) aus einem anderen Material wie das Gehäuse (1) gebildet ist.

9. Gehäuse nach einem der vorangehenden Ansprüche, **dadurch gekennzeichnet, dass** der Aufpralldämpfer (4 bis 16), insbesondere bei einer Schlagprüfung, flexibel ist.

10. Gehäuse nach einem der vorangehenden Ansprüche, **dadurch gekennzeichnet, dass** der Aufpralldämpfer (4 bis 16) lösbar an der Seitenfläche (3) befestigt ist, oder dass der Aufpralldämpfer (4 bis 16) einteilig mit dem Gehäuse (1) hergestellt ist.

11. Gehäuse nach einem der vorangehenden Ansprüche, **dadurch gekennzeichnet, dass** Aufpralldämpfer (4, bis 16) gruppenweise handhabbar und an der Seitenfläche (3) anbringbar sind.

12. Gehäuse nach einem der vorangehenden Ansprüche, **dadurch gekennzeichnet, dass** das Gehäuse (1) als explosionsgeschütztes Gehäuse ausgebildet ist.

13. Gehäuse nach einem der vorangehenden Ansprüche, **dadurch gekennzeichnet, dass** der Aufpralldämpfer (4 bis 16) an seinem freien Ende eine Abflachung und/oder Abrundung (26) aufweist, wobei insbesondere die Abflachung (26) einen Winkel (27) gegenüber der Seitenfläche (3) des Gehäuses (1) von mehr als 0° und weniger als 90° aufweist, insbesondere mehr als 10 und weniger als 89° und weiterhin insbesondere mehr als 20 und weniger als 70° aufweist.

14. Gehäuse nach einem der vorangehenden Ansprüche, **dadurch gekennzeichnet, dass** bei einer Schlagprüfung des Gehäuses nach entsprechender Norm ein Fallprüfhammer aus vorgegebener Fallhöhe mit bestimmter Beanspruchungsenergie von beispielsweise 4J, 7J, 20J oder dergleichen auf das Gehäuse auftrifft.

15. Gehäuse nach einem der vorangehenden Ansprüche, **dadurch gekennzeichnet, dass** die Aufpralldämpfer (4) in einem Abstand (25) geringer als eine entsprechende Breite eines Testelements (24) angeordnet sind.

## Claims

1. Housing (1) of an electrical/electronic operating means, such as a lamp, a terminal box, a control device, a switching distribution system or the like, comprising at least one side surface (3) which faces the external environment (2), a plurality of impact absorbers (4 to 16) being arranged on the side surface (3) so as to project at least from said side surface, **characterized in that** the impact absorbers (4 to 16) are used as cooling elements.

2. Housing according to claim 1, **characterized in that** the impact absorber (4 to 16) is rib-shaped or lamellar, and/or the impact absorbers (4 to 16) are arranged in rows and/or columns on the side surface (3).

3. Housing according to either claim 1 or claim 2, **characterized in that** the impact absorbers (4 to 16) each have the same cross section.

4. Housing according to any of the preceding claims, **characterized in that** impact absorbers (4 to 16) project at least from all side surfaces (3) and in particular from connecting edges between the side surfaces (3).

5. Housing according to any of the preceding claims, **characterized in that** the impact absorbers (4 to 16) are arranged with different cross sections and/or thicknesses (20) and/or lengths (21) and/or densities and/or orientations and/or shapes, and/or the impact absorber (4 to 16) protrudes substantially perpendicularly from the side surface (3).

6. Housing according to any of the preceding claims, **characterized in that** the impact absorber (4 to 16) extends so as to be inclined with respect to a plane (22) of the side surface (3).

7. Housing according to any of the preceding claims, **characterized in that** the impact absorber (4 to 16) has a predetermined breaking point.

8. Housing according to any of the preceding claims, **characterized in that** the impact absorber (4 to 16) is formed from a different material from the housing (1).

9. Housing according to any of the preceding claims, **characterized in that** the impact absorber (4 to 16) is flexible, in particular during an impact test.

10. Housing according to any of the preceding claims, **characterized in that** the impact absorber (4 to 16) is detachably fastened to the side surface (3), or **in that** the impact absorber (4 to 16) is produced in one piece with the housing (1).

11. Housing according to any of the preceding claims, **characterized in that** impact absorbers (4 to 16) can be handled in groups and can be attached to the side surface (3).

12. Housing according to any of the preceding claims, **characterized in that** the housing (1) is designed as an explosion-proof housing.

13. Housing according to any of the preceding claims, **characterized in that** the impact absorber (4 to 16) has a flattened portion and/or rounded portion (26) at its free end, in particular the flattened portion (26) having an angle (27) relative to the side surface (3) of the housing (1) of more than 0° and less than 90°, in particular more than 10 and less than 89°, and more particularly more than 20 and less than 70°.

14. Housing according to any of the preceding claims, **characterized in that,** during an impact test of the housing according to a corresponding standard, a drop test hammer hits the housing from a predetermined fall height with specific stress energy of, for example, 4J, 7J, 20J or the like.

15. Housing according to any of the preceding claims, **characterized in that** the impact absorbers (4) are arranged at a distance (25) of less than a corresponding width of a test element (24).

## Revendications

1. Boîtier (1) d'un équipement électrique/électronique tel qu'un luminaire, une boîte à bornes, un appareil de commande, une installation de distribution ou analogue, comportant au moins une face latérale (3) orientée vers l'environnement externe (2), une pluralité d'amortisseurs de chocs (4 à 16) étant disposés sur ladite face latérale au moins en saillie à partir de la face latérale (3),
**caractérisé en ce que** les amortisseurs de chocs (4 à 16) sont utilisés comme éléments de refroidissement.

2. Boîtier selon la revendication 1, **caractérisé en ce que** l'amortisseur de chocs (4 à 16) est conçu en forme de nervure ou de lamelle, et/ou les amortisseurs de chocs (4 à 16) sont disposés en rangées et/ou colonnes sur la face latérale (3).

3. Boîtier selon la revendication 1 ou 2, **caractérisé en ce que** les amortisseurs de chocs (4 à 16) présentent respectivement la même section transversale.

4. Boîtier selon l'une des revendications précédentes,
**caractérisé en ce que** des amortisseurs de chocs (4 à 16) font saillie au moins à partir de toutes les faces latérales (3) et en particulier à partir de bords de liaison entre les faces latérales (3).

5. Boîtier selon l'une des revendications précédentes,
**caractérisé en ce que** les amortisseurs de chocs (4 à 16) sont disposés avec des sections transversales et/ou épaisseurs (20) et/ou longueurs (21) et/ou densités et/ou orientations et/ou formes différentes, et/ou l'amortisseur de chocs (4 à 16) fait saillie de manière sensiblement perpendiculaire à partir de la face latérale (3).

6. Boîtier selon l'une des revendications précédentes,
**caractérisé en ce que** l'amortisseur de chocs (4 à 16) s'étend de manière inclinée par rapport à un plan (22) de la face latérale (3).

7. Boîtier selon l'une des revendications précédentes,
**caractérisé en ce que** l'amortisseur de chocs (4 à 16) présente un point de rupture cible.

8. Boîtier selon l'une des revendications précédentes,
**caractérisé en ce que** l'amortisseur de chocs (4 à 16) est formé à partir d'un autre matériau que celui du boîtier (1).

9. Boîtier selon l'une des revendications précédentes,
**caractérisé en ce que** l'amortisseur de chocs (4 à 16) est souple, en particulier lors d'un essai de choc.

10. Boîtier selon l'une des revendications précédentes,
**caractérisé en ce que** l'amortisseur de chocs (4 à 16) est fixé de manière amovible à la face latérale (3), **ou en ce que** l'amortisseur de chocs (4 à 16) est fabriqué d'une seule pièce avec le boîtier (1).

11. Boîtier selon l'une des revendications précédentes,
**caractérisé en ce que** des amortisseurs de chocs (4 à 16) peuvent être manipulés et montés sur la face latérale (3) en groupe.

12. Boîtier selon l'une des revendications précédentes,
**caractérisé en ce que** le boîtier (1) est conçu en tant que boîtier protégé contre les explosions.

13. Boîtier selon l'une des revendications précédentes,
**caractérisé en ce que** l'amortisseur de chocs (4 à 16) présente, au niveau de son extrémité libre, un aplatissement et/ou un arrondi (26), l'aplatissement (26) présentant en particulier un angle (27) par rapport à la face latérale (3) du boîtier (1) de plus de 0° et de moins de 90°, en particulier de plus de 10 et de moins de 89° et plus particulièrement de plus de 20 et de moins de 70°.

14. Boîtier selon l'une des revendications précédentes,
**caractérisé en ce que,** lors d'un essai de choc du boîtier selon une norme correspondante, un marteau d'essai de chute provenant d'une hauteur de chute prédéfinie rencontre le boîtier à une énergie de sollicitation déterminée de par exemple 4 J, 7 J, 20 J ou analogue.

15. Boîtier selon l'une des revendications précédentes,
**caractérisé en ce que** les amortisseurs de chocs (4) sont disposés à une distance (25) inférieure à une largeur correspondante d'un élément de test (24).
